# EUROPEAN PATENT APPLICATION

(11) **EP 1 162 651 A2**
(43) Date of publication of application: **12.12.2001**
(21) Application number: 01113981.3
(22) Date of filing: 08.06.2001
(51) Int. Cl.: H01L 21/00

(54) **Substrate rotating apparatus**

(30) Priority: 09.06.2000 JP 2000173689
(71) Applicant: EBARA CORPORATION, Ohta-ku, Tokyo (JP)
(72) Inventor: Shinozaki, Hiroyuki, Kamakura-shi, Kanagawa-ken (JP)
(74) Representative: Wagner, Karl H., Dipl.-Ing.

(57) **Abstract**

An apparatus for rotating a semiconductor substrate is provided which comprises a substrate holder for carrying the substrate thereon, a rotor for directly or indirectly supporting the substrate holder, a magnetic floating mechanism for magnetically floating and supporting the rotor in a non-contact state, and magnetic rotating mechanism for magnetically rotating the rotor. The magnetic floating mechanism and magnetic rotating mechanism are formed as a single integral unit structure. The unit structure includes a first set of windings for generating a magnetic field to provide the rotor with a rotating force, and a second set of windings for generating a magnetic field to float and support the rotor at a predetermined position. The first and second sets of windings are disposed on a single yoke plate made of a magnetic material.

## Description

The present invention relates to a substrate rotating apparatus, and in more detail to an apparatus for rotating a semiconductor substrate in a semiconductor device processing station where processes such as deposition, annealing, oxidization diffusion, sputtering, and etching of the semiconductor substrate are carried out.

In the field of a substrate rotating apparatus, an apparatus capable of rotating a semiconductor substrate at about 5 - 70 RPM is conventionally known, and is used in an anneal processing station to improve temperature distribution across the substrate. For example, U.S. Patent No. 5,965,047 describes such an apparatus, wherein a semiconductor substrate and a substrate holder are mounted on a cylindrical hollow rotor. The hollow rotor has a relatively large diameter and is supported by ball bearings, and a rotating force is transmitted to it through a main rotating shaft to which it is coupled by way of gears. Since the rotational speed of the rotor is relatively low and hence the circumferential speed of the rotor supporting members is relatively low even though the diameter of the rotor is relatively large, operation of the apparatus is feasible even if contact type bearings are employed.

In resent years, however, circuit patterns formed on semiconductor substrates used in manufacturing semiconductor devices have become increasingly narrow, and as a result, the prior art substrate rotating apparatus in which contact type bearings are employed is no longer suitable for use, due to the generation of particles and other contaminants. To satisfy the environmental strictures necessary for manufacture of semiconductor substrates, it is required to employ a substrate rotating apparatus in which magnetic bearings are employed to magnetically float and support a hollow rotor in a non-contact state.

U.S. Patent No. 6,022,413 describes a substrate rotating apparatus for use in substrate processing stations in which contact type bearings are not employed. The apparatus of the '413 patent includes a hollow rotor as a rotating component, which is floated by magnetic forces generated by magnetic bearings. The floated rotor is magnetically rotated by a motor.

However, the apparatus of the '413 patent suffers from a design impediment in that its structure extending in the direction of its vertical or rotational axis is excessively long. In addition, the diameter of the hollow rotor must be made relatively large in order to provide enough room for components of the apparatus extending through a central portion of the hollow rotor. In addition, the structure occupying a long space in the direction of the vertical axis is not desirable in term of maintenance of the apparatus.

Therefore, taking into account design requirements and maintenance of a substrate rotating apparatus, a unit comprising magnetic bearings and a motor should be made as flat as possible. U.S. Patent No. 5,818,137 discloses an apparatus in which magnetic bearings and a motor are combined or integrated into a flat unit. However, even this relatively flat unit is not yet sufficiently reduced in height due to restrictions imposed by the respective functions of the magnetic bearings and the motor. Specifically, since at least two stator yoke plates are required in the apparatus of '137 patent, a sufficiently flat unit is unable to be realized.

The present invention has been made in view of the problems described above. Consequently, it is an object of the present invention to provide an apparatus for rotating a semiconductor substrate, which is capable of meeting apparatus performances required for the manufacture of next-generation semiconductor devices with wiring widths (design rule) of 0.1 µm or less, and reducing the height and size of the apparatus by making integral with one another components required for generating forces for rotating and supporting a magnetic rotor.

To achieve the object of the present invention, an apparatus for rotating a semiconductor substrate comprises a substrate holder for carrying the substrate thereon, a rotor for directly or indirectly supporting the substrate holder, a magnetic floating mechanism for magnetically floating and supporting the rotor in a non-contact state, and magnetic rotating mechanism for magnetically rotating the rotor, wherein
the magnetic floating mechanism and magnetic rotating mechanism are formed as an integral unit structure,
the unit structure includes a first set of windings for generating a magnetic field to provide the rotor with a rotating force, and a second set of windings for generating a magnetic field to float and support the rotor at a predetermined position,
the first and second sets of windings are disposed on a single yoke plate made of a magnetic material.

In the apparatus described above, it is preferable that the rotor is formed to have in a ring-shaped, and that the ring-shaped rotor indirectly supports the substrate holder by way of supporting members. By utilizing such a ring-shaped rotor, the apparatus as whole is able to be formed to have a flat structure, thereby enabling a substrate having a large diameter to be processed.

It is also preferable that the apparatus comprises a barrier wall disposed between the outer surface of the rotor and the inner surface of the yoke plate, in contact with only the yoke plate, resulting in that the first and second sets of windings are positioned on the yoke plate outside the barrier wall. Since the sets of windings are separated, by the barrier wall, from a space where a substrate is processed, they are protected from corrosion which may otherwise occur within the space.

In the apparatus according to the present invention, it is further preferable to comprise beads made of a magnetic material which are embedded in portions of the barrier wall. These portions lay in magnetic flux paths through which magnetic fluxes generated from the first and second sets of windings pass. By employing the magnetic beads in the magnetic flux paths, a relatively large gap can be defined between the barrier and the ring-shaped rotor, resulting in that a large object-free margin is provided for whirling of the rotor.

Still further, it is preferable for the apparatus according to the present invention to comprise magnets disposed on the top surface of the yoke plate near the rotor or on the top surface of the rotor near the yoke plate, whereby magnetic fluxes are generated in a direction orthogonal to the top surface of the rotor. By use of such magnets, it is possible to improve the rigidity of passive stability axes.
Fig. 1 is a lateral cross-sectional view showing an exemplary structure of a substrate processing station which employs a substrate rotating apparatus according to the present invention;
Fig. 2 is a horizontal cross-sectional view along with the line A-A in Fig. 1, illustrating main components of a first embodiment of the substrate rotating apparatus according to the present invention, together with horizontal orthogonal axes X, Y of the apparatus;
Fig. 3 shows, on the cross-sectional view in Fig. 2, coordinate axes U, V, W of rotation driving windings, and coordinate axes α, β of position controlling windings of the substrate rotating apparatus according to the present invention;
Fig. 4 is a diagram illustrating an electric connection configuration for the rotation driving windings of the substrate rotating apparatus according to the present invention;
Fig. 5 is a diagram illustrating an electric connection configuration for the position controlling windings of the substrate rotating apparatus according to the present invention;
Fig. 6 is a diagram for explaining a relationship between a stator yoke plate and a barrier wall of the substrate rotating apparatus according to the present invention;
Fig. 7 illustrates a relationship among a ring-shaped rotor, orthogonal three-dimensional coordinates, and six degrees of freedom of a rigid body, in the substrate rotating apparatus according to the present invention;
Figs. 8A and 8B are plan and lateral views, respectively, of a first exemplary structure of the ring-shaped rotor for use in the substrate rotating apparatus according to the present invention;
Figs. 9A and 9B are plan and lateral views, respectively, of a second exemplary structure of the ring-shaped rotor for use in the substrate rotating apparatus according to the present invention;
Figs. 10A and 10B are plan and lateral views, respectively, of a third exemplary structure of the ring-shaped rotor for use in the substrate rotating apparatus according to the present invention;
Fig. 11 is a horizontal cross-sectional view illustrating main components of a second embodiment of a substrate rotating apparatus according to the present invention; and
Fig. 12 is a diagram illustrating an exemplary structure to improve rigidity of passive control axes of the substrate rotating apparatus, in accordance with the present invention.

Exemplary embodiments of the present invention will be described hereinafter with reference to the accompanying drawings.

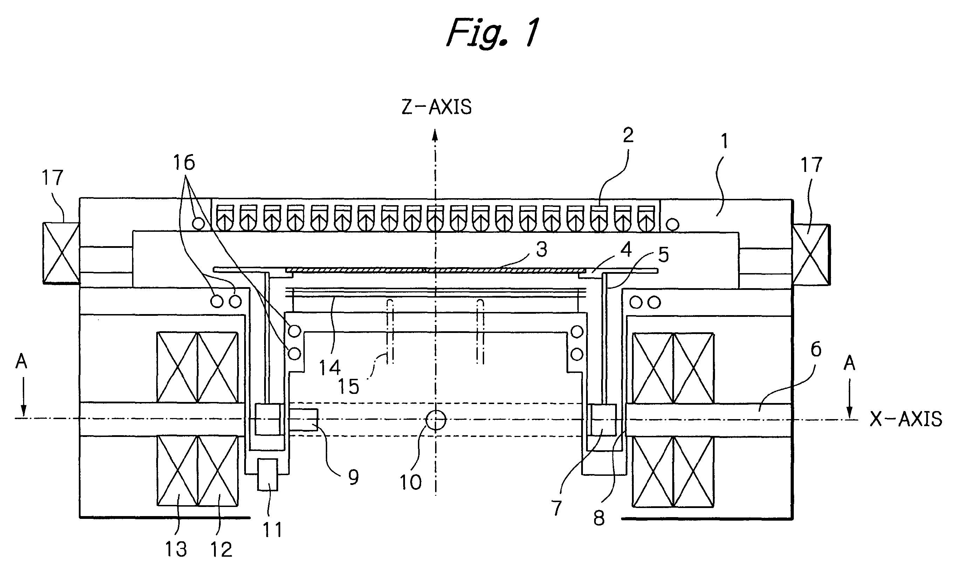

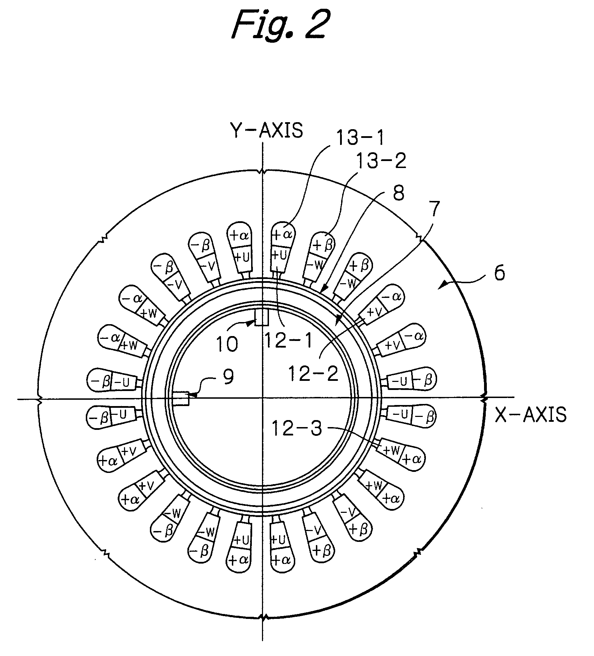

Fig. 1 is a lateral cross-sectional view illustrating a substrate processing station which employs an apparatus for rotating a semiconductor substrate according to the present invention. Fig. 2 is a horizontal cross-sectional view taken along a line A-A in Fig. 1 or the X-Y plane of the apparatus. The substrate processing station comprises a chamber 1 which in turn is provided with a large number of lamp heaters 2 disposed in an upper portion of a space within the chamber 1. The chamber 1 is also provided with a substrate holder 4 disposed in its internal space for carrying a target substrate 3 to be processed. The substrate holder 4 is supported through supporting members 5 on a ring-shaped rotor 7.

On the outer peripheral side surface of the ring-shaped rotor 7, a barrier wall 8 is disposed with a predetermined gap therebetween, and a stator yoke plate 6 is disposed in contact with the outer periphery of the barrier wall 8. In other words, the barrier wall 8 is in contact with the inner periphery of the stator yoke plate 6. Rotation driving windings 12 and position controlling windings 13 are secured on the stator yoke plate 6 at equal intervals in the circumferential direction as shown in Fig. 2. A displacement of the ring-shaped rotor 7 in the X-axis direction is detected by a displacement sensor 9, while a displacement thereof in the Y-axis direction is detected by a displacement sensor 10. The substrate processing station further comprises a rotation sensor 11 for detecting a rotational speed of the rotor 7, a reflector plate 14 which reflects irradiated heat from the lamp heaters 2, substrate push-up pins 15 for pushing up the substrate 3, coolant lines 16 for passing a coolant such as cooling water therethrough, and a gate valve 17.

The substrate holder 4, supporting members 5, the stator yoke plate 6, ring-shaped rotor 7, sensors 9 - 11, and sets of windings 12 and 13 on the plate 6 basically form the substrate rotating apparatus according to the present invention. However, the substrate holder may also be supported directly by the ring-shaped rotor 7 without the use of the supporting members 5.

In the substrate processing station as described above, three-dimensional orthogonal coordinates are provided with the vertical axis being assigned as a Z-axis. The target substrate 3 is inserted into the center of the chamber 1, mounted on the substrate holder 4, and then subjected to a desired processing. When the substrate 3 should be rotated during such processing, the substrate 3 is rotated around the Z-axis by the substrate rotating apparatus. The lamp heaters 2 disposed above the substrate 3, supply the substrate 3 with thermal energy required for the processing. The ring-shaped rotor 7 is magnetically coupled to the stator yoke plate 6 and supported thereby. The stator yoke plate 6 is isolated from the substrate processing space of the chamber 1 by the barrier wall 8 as mentioned above. In other words, the stator yoke plate 6, rotation driving windings 12 and position controlling windings 13 are disposed outside the space where the substrate 3 is placed.

The target substrate 3 may be a silicon substrate, quartz substrate, germanium substrate, or the like. The substrate holder 4 may be made of a material such as quartz, silicon carbide (SiC), steatite (MgO·SiO₂), mullite (3Al₂O₃·2SiO₂), or the like. The supporting member 5 may be made of a material such as quartz, silicon carbide (SiC), steatite (MgO·SiO₂), mullite (3Al₂O₃·2SiO₂), stainless steel or the like. The ring-shaped rotor 7 may be made of a magnetic material such as permalloy (PB, PC), electromagnetic stainless steel, Fe-Si steel, electromagnetic soft iron (SUY-B, SUY-P) or the like. When a permanent magnet is used as the rotor 7, a samarium/cobalt based magnet or an iron/neodymium/boron based magnet is applicable. Also, for improving the corrosion resistance, coating such as nickel plating is applied to the rotor 7.

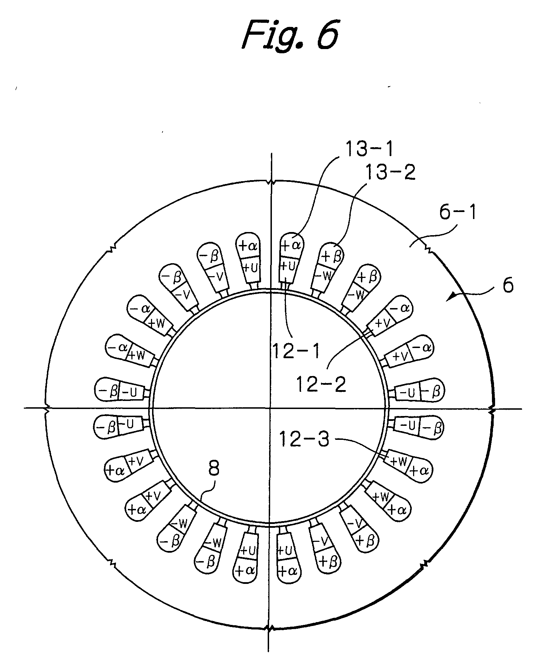

The barrier wall 8 may be made of a non-magnetic material formed to have a cylindrical shape, and is in contact with the inner peripheral surface of the stator yoke plate 6, as is clearly illustrated in Fig. 6. A non-magnetic material suitable for the barrier wall 8 may be an austenite-based stainless steel (SUS316, SUS304), polyether/ether ketone (PEEK) material, an aluminum alloy, and so on.

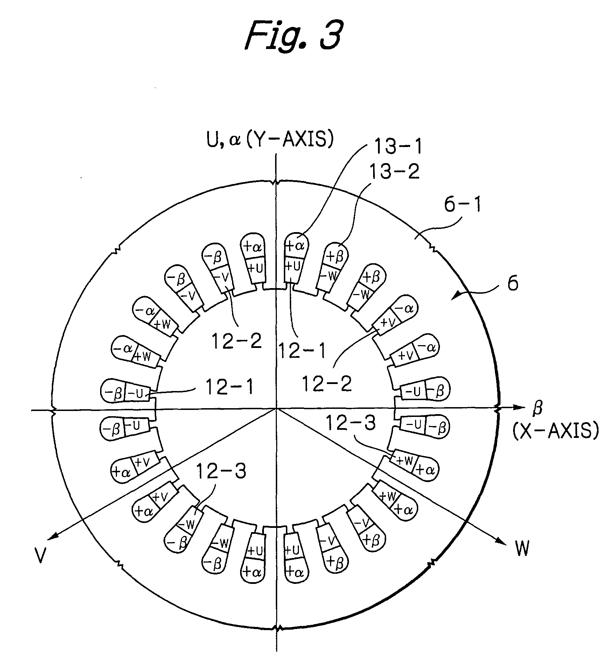

The stator yoke plate 6 is comprised, as shown in Fig. 3, of a yoke plate 6-1, the rotation driving windings 12 and the position controlling windings 13. The windings 12 are grouped into three types of windings 12-1, 12-2, 12-3 for U, V and W phases, respectively. The windings 12-1 comprises +U and -U phase winding components, the windings 12-2 comprises +V and -V phase winding components, and the windings 12-3 comprises +w and -w phase winding components. These winding components are located as illustrated in Fig. 3. The windings 13 are grouped into two types of windings 13-1, 13-2. The windings 13-1 comprises +αα and-α axis winding components, and the windings 13-2 comprise +β and -β axis winding components. These winding components are located as illustrated in Fig. 3. The yoke plate 6-1, which is made of a magnetic material, may be comprised of a structure of laminated silicon steel plates, such as solid permalloy (PB, PC), electromagnetic stainless steel plates or Fe-Si steel plates. A structure which produces the least possible eddy current loss is preferred as the yoke plate. Specifically, a laminate of thin plates, and a material having a high resistance should be used as the plate 6-1. Fig. 3 also shows a relationship among the coordinate axes U, V, W of the rotation driving windings 12, the coordinate axes α, β of the position controlling windings 13, and the horizontal orthogonal coordinates X, Y. As illustrated in Fig. 3, the coordinate axes α and β of the position control windings 13 are respectively coincident with the horizontal orthogonal coordinates Y and X.

Each of the rotation driving windings 12 has a structure equivalent to a winding of a conventional motor, and may be made of a quite normal wiring material. The same applies to each of the position controlling windings 13.

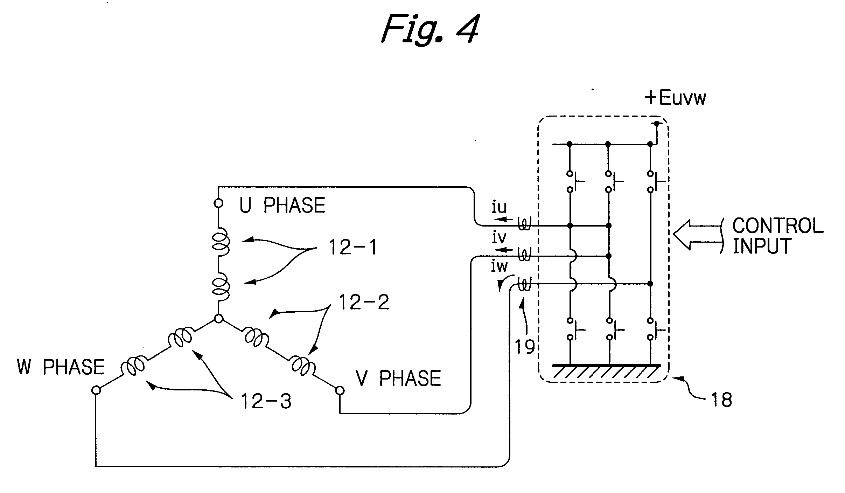

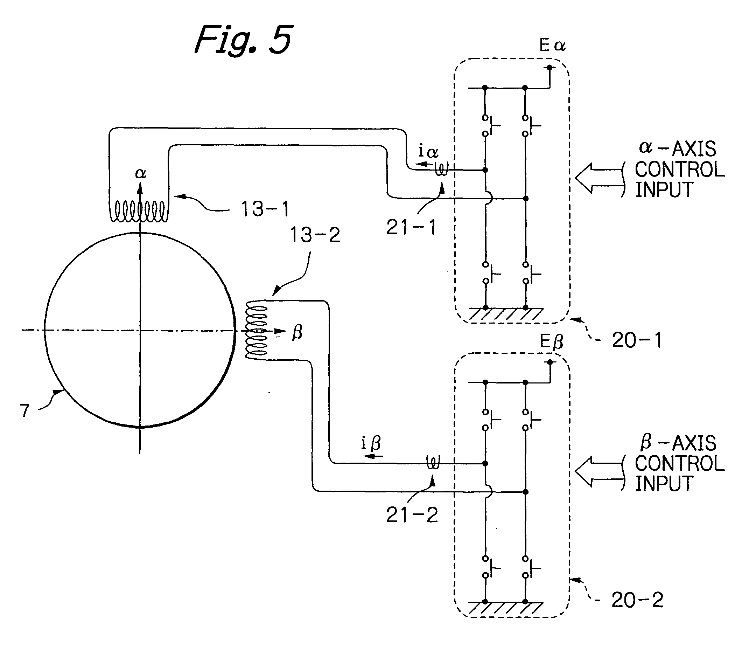

Fig. 4 illustrates an electrical connection for the rotation driving windings 12 which are grouped to the winding components 12-1, 12-2, 12-3, and Fig. 5 illustrates an electrical connection for the position controlling windings 13 which are grouped to the winding components 13-1, 13-2. As illustrated in Fig. 4, the +U and -U phase winding components 12-1, +V and -V phase winding components 12-2 and +W and -W phase winding components 12-3 are connected in a star configuration. A U-phase current iu, V-phase current iv, and W-phase current iw are supplied from an intelligence power module (IPM) 18, respectively. A phase current detector 19 having three current detection components is provided to detect the respective phase currents iu, iv, iw. Here, the IPM 18 may be one that is commonly used as a conventional motor controller, and the phase current detector 19 may be one that is commercially available. The phase currents detected by the phase current detector 19 are used for creating control signals which are supplied to a vector control drive for a motor and the position controlling windings 13.

On the other hand, as shown in Fig. 5 as well as Fig. 3, the coordinate axes α, β of the winding components 13-1, 13-2 are positioned in correspondence to (in alignment with) the horizontal plane motion coordinate axes X, Y of the rotor 7, and the winding components 13-1, 13-2 are supplied with currents iα, iβ from IPM 20-1, IPM 20-2, respectively. The currents are detected by detectors 21-1 and 21-2, respectively. In the constitution illustrated in Fig. 5, since the coordinate axes α, β of the winding components 13-1, 13-2 are positioned in correspondence to (in alignment with) the horizontal plane motion coordinate axes X, Y, control signals (illustrated as α-axis and β-axis control inputs in Fig. 5) are processed in a controller (not shown), based on signals emitted from the displacement sensors 9 and 10 for the X-axis and the Y-axis. Therefore, the IPMs 20-1, 20-2 are controlled by the control signals, and can supply the currents iα, iβ to the winding components 13-1, 13-2, respectively. This results in elimination of phase conversion to a power unit control signal for adjusting the winding currents.

It should be noted that, in order to process the position control signals in the controller (not shown), an output of the rotation sensor 11, and respective phase current values of the components 12-1 - 12-3 of the rotation driving windings 12 and respective phase current values of the components 13-1, 13-2 of the position controlling windings 13 may be utilized in addition to the outputs of the displacement sensors 9, 10.

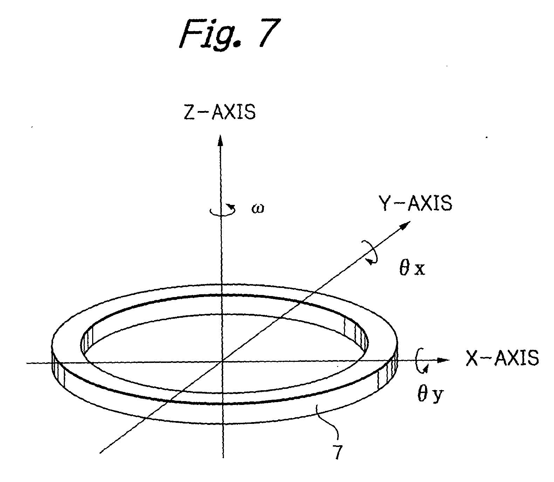

Fig. 7 is an explanatory view for showing six degrees of freedom of the ring-shaped rotor 7 as a rigid body. As shown in Fig. 7, the six degrees of freedom of the rotor include (1) a translational motion along the X-axis in the horizontal direction, (2) a translational motion along the Y-axis in the horizontal direction, (3) a translational motion along the Z-axis in the vertical direction, (4) a gradient motion θy about the X-axis, (5) a gradient motion θx about the Y-axis, and (6) a rotational motion ω.

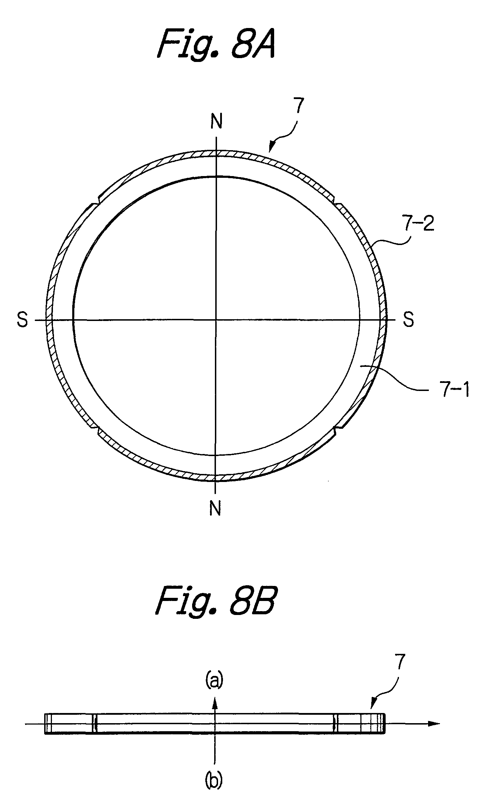

Figs. 8A and 8B are plan and lateral views of a first embodied structure of the ring-shaped rotor 7, respectively. The ring-shaped rotor 7 is a permanent magnet type, comprising a ring 7-1, and a permanent magnet 7-2 secured on the outer periphery of the ring 7-1. The ring 7-1 is made of a solid magnetic material, for example, PB, PC, Fe-Si, SUY-B, electromagnetic stainless, or the like. The permanent magnet 7-2 is divided into four sections, a facing or opposite pair of which are magnetized to the N-pole and the other pair of which are magnetized to the S-pole. The permanent magnet 7-2 is made of Sm-Co based (samarium-cobalt based) magnet, Nd-Fe-B based (neodium-iron-boron based) magnet or the like. The structure of the ring-shaped rotor 7 can readily ensure the rigidity of the passive control axes (passive stability axes) and a high motor efficiency. Generally, such a structure is referred to as a brush-less DC motor.

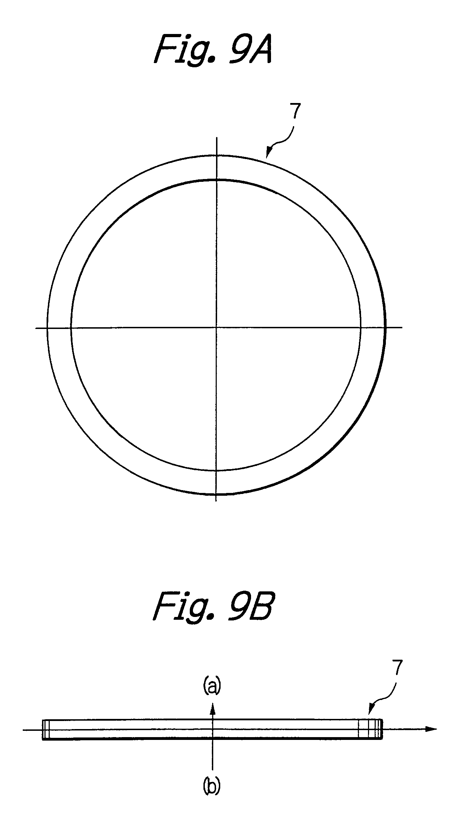

Figs. 9A and 9B are plan and lateral views of a second embodied structure of the ring-shaped rotor 7, respectively. The second ring-shaped rotor is an induction type, which essentially requires a cage circuit that acts as a secondary current path in the ring-shaped rotor 7. However, in stead of the cage circuit, the ring-shaped rotor 7 in this embodiment is made of a solid magnetic material, for example, PB, PC, Fe-Si, electromagnetic stainless, SuY-B, or the like to reduce the size.

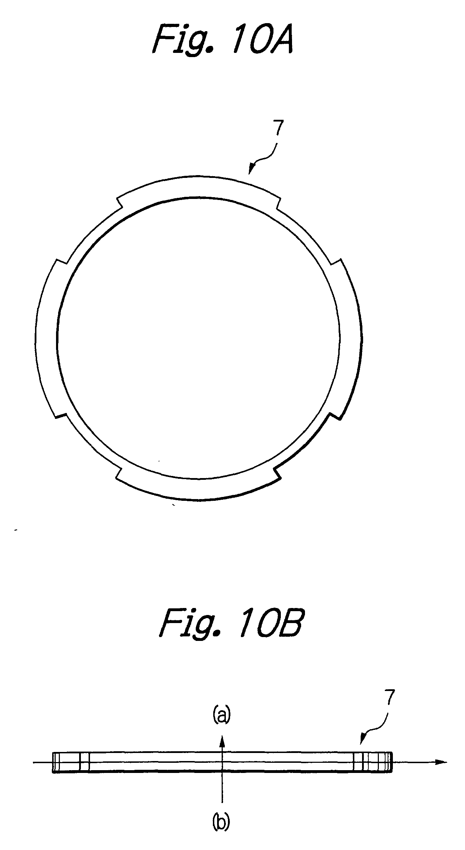

Figs. 10A and 10B are plan and lateral views, respectively, of a third embodied structure of the ring-shaped rotor 7. The third ring-shaped rotor 7 is a reverse salient pole type, which is employed when a reluctance motor is used.

Generally, when the six degrees of freedom of the ring-shaped rotor 7 are represented in the orthogonal coordinate system X, Y, Z as shown in Fig. 7 and Z-axis is assigned as a rotation axis, a total of five degrees of freedom must be supported, including the translational motions in the orthogonal X-axis and Y-axis directions, the gradient motions θy, θx about the X-axis and Y-axis, and the translational motion in the Z-axis direction. For this reason, two radial magnetic bearings or bearing-less motors are required, which are disposed in the direction of the rotation axis Z to stably support four degrees of freedom: the translational motions along the X- and Y-axes and the gradient motions about the X- and Y-axes. Other magnetic bearings are also required for the translational motion along the Z-axis. Accordingly, a plurality of yoke plates wrapped with windings are required.

However, in the apparatus for rotating a semiconductor substrate, especially having a large-diameter, according to the present invention, instead of five degrees of freedom (except for the motion of a rigid body about the rotation axis), three degrees of freedom including the translational motion along the Z-axis and the gradient motions about X- and Y-axes are supported by a passive control (passive stability), while only the translational motions along the X- and Y-axes in the radial direction are supported by an active control, on the basis of "specificities". Therefore, a fully non-contact support of the rotor 7 can be achieved. In the following, the specificities will be enumerated to demonstrate how fully non-contact function can be achieved.
A) The diameter of the ring-shaped rotor (hollow rotor) 7 is large, for instance in a range of 300 to 450 mm:
   Thus, the stator yoke plate 6 has a large inner peripheral length. For this reason, even if only a small restoring force in the Z-axis direction per unit peripheral length results from a magnetic suction force acting between the stator yoke plate 6 and the ring-shaped rotor 7, the totaled restoring force over the entire inner periphery may be obtained.
B) A static load in the direction of the vertical axis (Z-axis) is small:
   The gravitational force acting on the ring-shaped rotor 7 is equal only to the sum of weights of the target substrate 3, substrate holder 4 and ring-shaped rotor 7. The substrate 3 has a weight of 100 g at most, and thus when the substrate holder 4 and the ring-shaped rotor 7 are reduced in weight, the gravitational force will be correspondingly reduced.
C) A dynamic load in the vertical direction (Z-axis) is substantially zero:
   Therefore, it is not essential to actively control the Z-axis because of the reasons set forth in B) and C).
D) The rotor is flat:
   Thus, the gradient motions of the rotor are stabilized by virtue of the gyro effect of the rotor 7. Accordingly, it is not essential to actively control the gradient motions about the horizontal axes X and Y.

In the present invention, in view of the foregoing specificities A) - D), the single stator yoke plate 6 is provided with two sets of windings, one set of which are used as the rotation driving windings 12 for generating a rotation driving magnetic field, and the other set of which is used as the position controlling windings 13 for controlling the position of the rotor 7. In this way, the respective forces associated with the rotation driving and supporting of the rotor 7 are integrally combined, thereby allowing a reduction in height and size of the substrate rotating apparatus.

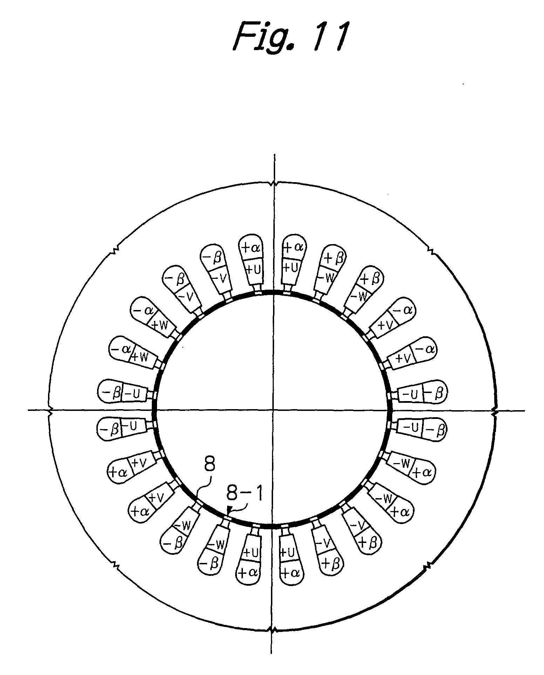

Fig. 11 is a horizontal cross-sectional view showing main components of a second embodiment of the substrate rotating apparatus according to the present invention. The second embodiment differs from the first embodiment shown in Fig. 2 in the structure of the barrier wall 8. Specifically, in the first embodiment, there is a gap or a non-magnetic space interposed between the barrier wall 8 attached to the stator yoke plate 6 and the ring-shaped rotor 7. This gap functions as a main resistance on the magnetic circuit in the first embodiment.

In the second embodiment as shown in Fig. 11, to decrease the magnetic resistance, magnetic beads 8-1 are embedded in portions of the barrier wall 8 which is made of a non-magnetic material. The embedded beads 8-1 are located at magnetic paths in the barrier wall 8 where magnetic fluxes generated from the sets of windings 12 and 13 pass through. To achieve this object, the beads 8-1 are located in positions which correspond to the sets of windings 12 and 13.

Specifically, supposing that the distance between the inner surface of the stator yoke plate 6 and the outer surface of ring-shaped rotor 7 is the same in the first and second embodiments, the main resistance on the magnetic circuit in the second embodiment will be lower than that in the first embodiment. This is because of the effect the beads 8-1 have in lowering magnetic resistance. It is, therefore, possible to increase the efficiency of the magnetic force in the second embodiment. Alternatively, supposing that the distance of the gap between the inner surface of the barrier wall 8 and the outer surface of the ring-shaped rotor 7 is the same in the first and second embodiments, a wider gap can be defined in the second embodiment in comparison with the first embodiment. This is advantageous in that a larger margin can be ensured for whirling of the ring-shaped rotor 7.

In both of the embodiments, it is necessary to take into account a secondary current generated in the non-magnetic region of the barrier wall 8. Namely, it is desirable to set an electric resistance of the secondary current path to be as large as possible. For this purpose, a material having a high electrical resistance may be employed as the barrier wall 8. Alternatively, it is possible to make slits or the like in the secondary current path in the barrier wall.

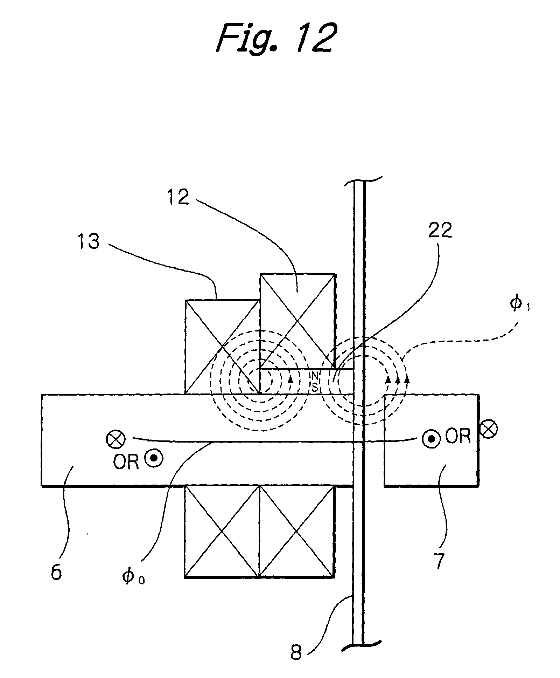

Fig. 12 illustrates an exemplary structure for improving the rigidity of the passive control axes (passive stability axes), i.e., translation in the Z-axis direction, θy gradient, and θx gradient. Here, a permanent magnet 22 is disposed at an inner peripheral end of the top surface of the stator yoke plate 6 such that the poles of the magnet 22 are positioned in the Z-axis direction. By disposing the permanent magnet 22 at the inner leading end on the top surface of the stator yoke plate 6, the magnetic fluxes Φ₁ flow upwardly from the top surface of the ring-shaped rotor 7, causing a suction force to act in the Z-axis direction relative to the rotor 7. In this way, it is possible to improve the rigidity of the passive stability axes, i.e., translation in the Z-axis direction, θy gradient about the X-axis, and θx gradient about the Y-axis. Alternatively, the permanent magnet 22 may be disposed on the top surface of the ring-shaped rotor 7 to flow magnetic fluxes upwardly from the top surface of the rotor 7. For reference, in Fig. 13, Φ₀ designates a magnetic fluxes for rotation driving and position control.

According to the substrate rotating apparatus of the present invention described above, the following advantages can be realized:

In the substrate rotating apparatus, a set of coils or windings for generating a rotary magnetic field to provide a rotor with a rotating force and a set of coils or windings for generating a position controlling magnetic field to float and support the rotor at a predetermined position are disposed on a single yoke plate made of a magnetic material, thereby making it possible to simplify the apparatus and reduce its height and size. In addition, it is possible to reduce costs of the apparatus over the conventional art, while at the same time providing greater freedom of design of the apparatus.

By employing a ring-shaped rotor in the apparatus, a substrate having a larger diameter can be processed in a substrate processing station employing the rotating apparatus. It is also possible to reduce the height of the apparatus.

When a barrier wall is disposed between the rotor and the yoke plate, the set of windings for generating the rotary magnetic field and the set of windings for generating the position control magnetic field are positioned outside of the barrier wall. Accordingly, the sets of windings are located outside of a processing space in which the substrate is loaded, and hence the sets of coils can be protected from corrosion which may otherwise result when a corrosive gas or the like is used in the space.

When beads made of a magnetic material are embedded in portions of the barrier wall to form magnetic paths along which magnetic fluxes pass, a wider gap can be defined between the inner surface of the barrier wall and the outer surface of the ring-shaped rotor, thereby making it possible to ensure a larger margin for whirling of the ring-shaped rotor. Further, the main magnetic resistance on the magnetic circuit is reduced, thereby making it possible to increase the efficiency of the magnetic force.

Still further, since a magnet is disposed on the top surface of the yoke plate near the rotor, or on the top surface of the rotor near the yoke plate to generate magnetic fluxes in a direction orthogonal to the top surface of the yoke plate, the rigidity of passive stability axes can be improved.

While there has been described what are at present considered to be preferred embodiments of the invention, it will be understood that various modifications may be made therein, and it is intended to cover in the appended claims all such modifications as fall within the spirit and scope of the invention.

## Claims

1. An apparatus for rotating a semiconductor substrate comprising a substrate holder for carrying the substrate thereon, a rotor for directly or indirectly supporting the substrate holder, a magnetic floating mechanism for magnetically floating and supporting the rotor in a non-contact state, and magnetic rotating mechanism for magnetically rotating the rotor, wherein
the magnetic floating mechanism and magnetic rotating mechanism are formed as a single integral unit structure,
the unit structure includes a first set of windings for generating a magnetic field to provide the rotor with a rotating force, and a second set of windings for generating a magnetic field to float and support the rotor at a predetermined position,
the first and second sets of windings are disposed on a single yoke plate made of a magnetic material.

2. An apparatus according to Claim 1, wherein the rotor is a ring-shaped rotor, and the ring-shaped rotor indirectly supports the substrate holder by way of supporting members.

3. An apparatus according to Claim 1, further comprising a barrier wall disposed between the outer surface of the rotor and the inner surface of the yoke plate in contact with only the yoke plate, resulting in that the first and second sets of windings are positioned on the yoke plate outside the barrier wall.

4. An apparatus according to Claim 1, further comprising beads made of a magnetic material which are embedded in portions of the barrier wall, the portions lying in magnetic paths along which magnetic fluxes generated by the first and second sets of windings pass.

5. An apparatus according to Claim 1, further comprising
magnets disposed on the top surface of the yoke plate near the rotor or on the top surface of the rotor near the yoke plate, for generating magnetic fluxes in a direction orthogonal to the top surface of the rotor to thereby improve the rigidity of passive stability axes.

6. An apparatus according to Claim 1, wherein the first set of windings comprise +U, -U, +V, -V, +W and -W phase winding components and the second set of windings comprise α and β axis winding components, each component of the first set of windings is positioned correspondingly to each component of the second set of windings, and the pairs of the components of the first and second sets of windings are located on the yoke plate at the vicinity of the inner surface thereof and at equal intervals in the circumferential direction thereof.

7. An apparatus according to Claim 7, wherein the α and β axes are set to coincidence with the X and Y of the horizontal plane motion coordinate.
